# FASCICULE DE BREVET EUROPEEN

(11) **EP 3 772 747 B1**
(45) Date de publication et mention de la délivrance du brevet: **13.09.2023**
(21) Numéro de dépôt: 20188669.4
(22) Date de dépôt: 30.07.2020
(51) Int. Cl.: H01L 21/67, H01L 21/683

(54) **OUTIL DE POSITIONNEMENT**
POSITIONIERUNGSWERKZEUG
POSITIONING TOOL

(30) Priorité: 05.08.2019 FR 1908964
(43) Date de publication de la demande: 10.02.2021
(73) Titulaire: Trixell, 38430 Moirans (FR)
(72) Inventeur: JANVIER, Yannick, 38430 MOIRANS (FR)
(74) Mandataire: Atout PI Laplace

(56) Documents cités:
- WO-A1-2012/117509
- FR-A1- 2 516 432
- KR-B1- 101 045 622
- KR-B1- 101 045 622
- US-B2- 8 580 654

## Description

L'invention se situe dans le domaine technique de positionnement précis de plaque plane pouvant avoir des grandes dimensions. Plus particulièrement, l'invention s'applique aux domaines nécessitant un collage précis (pouvant atteindre des précisions inférieures à 20 µm (micromètres)) de puces de semi-conducteur de grandes dimensions (pouvant atteindre plusieurs centaines de millimètres) tels que des capteurs digitaux, par exemple pour l'imagerie médicale sous X en technologie CMOS.

Lors de l'assemblage d'une puce de semi-conducteur, la puce est saisie et positionnée à l'endroit voulu sur le support recouvert d'un film adhésif. Les systèmes de report connus sont dénommés systèmes de report « pick and place » signifiant que l'on prend la puce et on la place. Du fait de la petite dimension de la puce (généralement inférieure à 50 mm x 50 mm), ce type de système de report est adapté et aucun problème de positionnement n'est à déplorer. Autrement dit, les systèmes de report connus de l'art antérieur ne sont adaptés que pour des puces de petites dimensions.

Dans le cas de report d'une puce de grandes dimensions, il est impossible avec les systèmes de report de l'art antérieur de réaliser un report plan à plan. En effet, en phase d'approche de la puce vers son support de destination, on constate un effet microscopique : un bord ou un coin de la puce touche une partie du film adhésif recouvrant le support, ou bien la puce glisse au moment de la mise en contact avec le film adhésif. Il en résulte que la puce est décalée par rapport à son positionnement souhaité sur le support.

Un autre problème qui apparaît du fait des grandes dimensions d'une puce est le collage non-uniforme de la puce sur son support. Lors de la phase de collage de la puce sur son support, c'est-à-dire entre deux surfaces planes sensiblement parallèles, des bulles d'air peuvent se former dans le film adhésif. De ce fait, les spécifications d'altimétrie imposant une tolérance d'écart selon un axe Z entre les surfaces de puces adjacentes s'étendant dans un plan perpendiculaire à l'axe Z ne peuvent être respectées.

Les solutions existantes ne sont pas satisfaisantes car elles ne permettent ni la manipulation et l'alignement précis de puces de grandes dimensions. De plus, elles n'assurent pas l'absence de bulles à l'interface entre le film adhésif et la plaque CMOS.

Les documents suivants sont mentionnés en tant qu'illustration de l'état de l'art, et décrivent deux variantes d'outils de manipulation et de positionnement de plaque plate:
WO 2012/117509 A1
US 8 580 654 B2

Autrement dit, les solutions existantes connues ne permettent pas d'éviter le risque d'accostage sur une arête ou un coin de la puce, rendant impossible toute maîtrise des effets de mouvements parasites lors de la phase de collage de la puce de grandes dimensions sur son support.

L'invention vise à pallier tout ou partie des problèmes cités plus haut en proposant un outil permettant la préhension et l'opération de report, collage d'une puce, même de grandes dimensions, sur un film adhésif sur un capteur en garantissant la précision de positionnement par la réduction des effets de mouvements mécaniques lors de la prise de contact avec le film adhésif, ainsi qu'en conservant l'intégrité du capteur. L'outil proposé écarte les risques d'indentation des couches de la puce. En outre, il permet l'utilisation de consommables standard offrant un large choix de duretés et de caractéristiques électriques, afin d'assurer l'aspect dissipatif pour éviter les décharges électrostatiques.

A cet effet, l'invention a pour objet un outil de positionnement apte à positionner une plaque plane sur un support plan, tel que divulgué dans la revendication 1.

Avantageusement, le dispositif d'incurvation est un contact ponctuel.

Avantageusement, le dispositif d'incurvation est positionné entre les au moins deux ventouses.

Avantageusement, les au moins deux ventouses comprennent du silicone.

Le dispositif d'incurvation peut être un doigt presseur, un ressort, une ventouse à soufflet, une vis de pression ou une rotule.

L'invention concerne aussi un procédé de courbure ponctuelle d'une plaque plane pour positionner la plaque plane sur un support plan, tel que divulgué dans la revendication 6.

Le procédé peut comprendre après l'étape d'incurvation de la plaque plane une étape de mise en contact du point de courbure de la plaque plane incurvée avec le support plan.

Le procédé peut comprendre après l'étape de mise en contact une étape de libération de la plaque plane sur le support plan.

L'invention sera mieux comprise et d'autres avantages apparaîtront à la lecture de la description détaillée d'un mode de réalisation donné à titre d'exemple, description illustrée par le dessin joint dans lequel :
[Fig.1] La figure 1 représente schématiquement un outil de positionnement selon l'invention ;
[Fig.2] La figure 2 représente schématiquement un mode de réalisation de l'outil de positionnement selon l'invention ;
[Fig.3] La figure 3 représente schématiquement les étapes du procédé de positionnement d'une plaque plane sur un support plan selon l'invention ;
[Fig.4] La figure 4 représente schématiquement l'outil de positionnement selon l'invention lors de l'étape de préhension de la puce;
[Fig.5] La figure 5 représente schématiquement l'outil de positionnement selon l'invention lors de l'étape d'incurvation de la puce ;
[Fig.6] La figure 6 représente schématiquement l'outil de positionnement selon l'invention après l'étape de mise en contact de la puce sur son support.

Sur ces figures, dans un souci de clarté, les échelles ne sont pas respectées. Par ailleurs, les mêmes éléments porteront les mêmes repères dans les différentes figures.

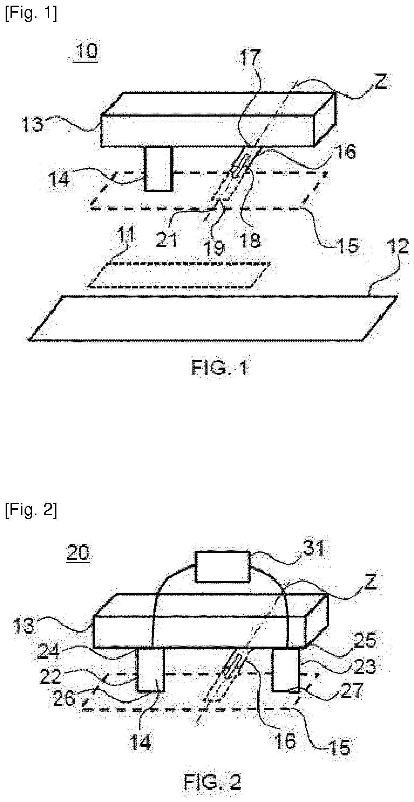

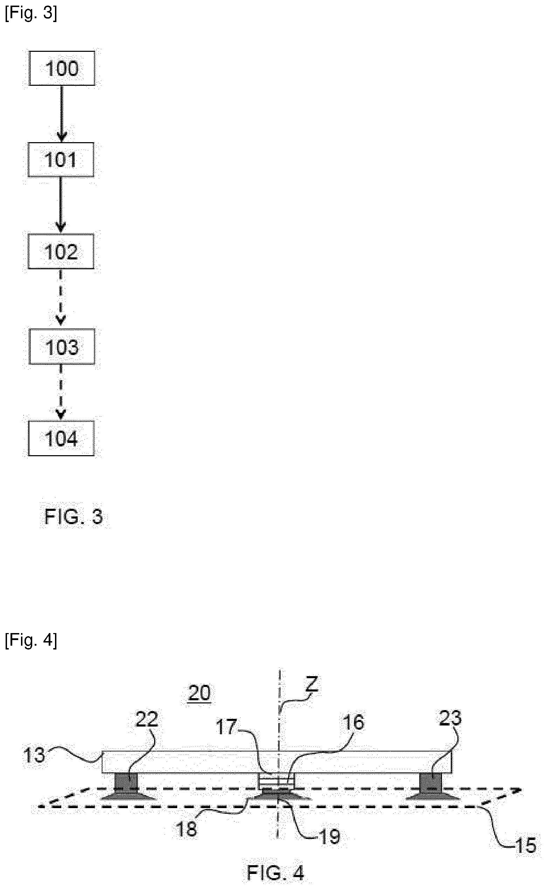

La figure 1 représente schématiquement un outil de positionnement 10 selon l'invention. L'outil de positionnement 10 est apte à positionner une plaque plane 11, par exemple une puce, sur un support plan 12, par exemple un capteur. L'outil de positionnement comprend une base 13, un dispositif de préhension 14 relié à la base 13, définissant un plan de préhension 15. Le plan de préhension 15 est sensiblement parallèle au support plan 12, de sorte à saisir la plaque plane 11 et la maintenir dans le plan de préhension 15. L'outil de positionnement 10 comprend un dispositif d'incurvation 16, ayant une première extrémité 17 reliée à la base 13 et une deuxième extrémité 18 mobile en translation selon un premier axe Z sécant, préférentiellement sensiblement perpendiculaire, à travers le plan de préhension 15 en un point de contact 19. A noter que le plan de préhension 15 est un plan virtuel. Le point de contact 19 est un point de ce plan de préhension 15. Il s'agit du point où la deuxième extrémité 18 du dispositif d'incurvation 16 entre en contact avec le plan de préhension 15. Lorsque l'outil de positionnement 10 saisit une plaque plane 11, la plaque plane 11 est maintenue dans le plan de préhension 15. Ensuite, la deuxième extrémité 18 du dispositif d'incurvation 16 se translate selon l'axe Z et entre en contact avec la plaque plane 11 au point de contact 19, ou bien entre en contact avec la plaque plane 11 et se translate simultanément par effet de contrainte comme expliqué un peu plus loin dans le mode de réalisation de la figure 2. Par translation de la deuxième extrémité 18 par rapport à la plaque plane 11, la plaque plane 11 se courbe au niveau d'un point de courbure 191 (visible sur la figure 4). Le dispositif d'incurvation 16 est configuré pour définir un point de courbure sur la plaque plane 11, de sorte à courber la plaque plane 11 en ce point de courbure 191.

L'outil de positionnement 10 permet de créer une courbure maîtrisée de la plaque plane 11 (par exemple la puce) pour permettre un accostage à un point prédéterminé de la plaque plane 11 (par exemple au centre de la puce) et limiter ainsi les effets de mouvement de la puce lors de la phase de collage. Autrement dit, l'outil de positionnement 10 selon l'invention permet d'une part de saisir une puce de grandes dimensions et de la maintenir en position selon un plan, et d'autre part d'appliquer une force sur la puce, en un point prédéfini de la puce, préférentiellement son centre, pour la courber en ce point. La puce étant fragile, l'application de la force est contrôlée pour obtenir une courbure contrôlée de la puce. L'application de la force par le dispositif d'incurvation est adaptée de sorte à maintenir la courbure de la puce jusqu'à la mise en contact de la puce avec son support au point souhaité. En d'autres termes, le dispositif d'incurvation peut être un simple contact ponctuel 21. Le point de courbure de la puce est mis en contact avec le support. Une fois la puce et son support mis en contact, le dispositif de préhension 14 relâche sa prise. Autrement dit, il libère la puce qui revient alors dans sa position plane initiale et prend place sur le support plan. La libération de la puce peut également être contrôlée comme explicité ci-dessous.

Les avantages de l'outil de positionnement selon l'invention sont multiples. Un tel outil de positionnement permet le report de puces de toutes dimensions, même les grandes dimensions, avec une précision dans la gamme des +/- 20 µm (micromètres) en limitant les effets de décalage lors de l'accostage sur film adhésif, tout en garantissant l'intégrité mécanique et électrique du capteur sur lequel la puce est collée. Par grandes dimensions, on entend des puces de dimensions supérieures à 20 mm x 20mm, par exemple 50mm x 50mm, 70 mm x 110 mm, 100 mm x 50 mm, 100 mm x 150mm, voire 200 mm x 200 mm et plus.

En outre, du fait de la courbure de la puce au point de courbure, le collage de la puce sur le capteur se fait du centre de la puce vers le bord, ce qui a pour effet de limiter la création de bulles à l'interface entre la puce et le film adhésif déposé sur le capteur. Cela permet d'obtenir plus facilement une structure hermétique et étanche. En effet, la garantie d'un collage du centre vers les bords offert par l'outil de positionnement selon l'invention limite les effets de collage contraint sur les bords qui rendrait difficile voire impossible un collage périphérique étanche. Ce dernier point est lié aux étapes ultérieures de suppression des bulles à l'interface nécessitant un collage continu et hermétique des bords de la puce.

La figure 2 représente schématiquement un mode de réalisation de l'outil de positionnement 20 selon l'invention. Dans ce mode de réalisation, le dispositif de préhension 14 comprend au moins deux ventouses 22, 23, chacune ayant une première extrémité 24, 25 reliée à la base 13 et une deuxième extrémité 26, 27 située dans le plan de préhension 15. Sur la figure 2, deux ventouses 22, 23 sont représentées. Le dispositif de préhension 14 peut aussi en comprendre 3, ou avantageusement 4, réparties sur la base 13 et avantageusement positionnées à proximité des bords de la base 13. Il peut aussi comprendre plus que 4 ventouses. Les deuxièmes extrémités 26, 27 des ventouses se situent dans le plan de préhension 15. Avant la préhension de la puce par l'outil de positionnement 20, la puce est positionnée sur un support initial plan. Quand l'outil de positionnement 20 prend une puce, nous avons deux cas de figure. Soit la deuxième extrémité 18 du dispositif d'incurvation 16 se trouve dans le plan de contact 15 ou n'est pas encore en contact avec le plan de contact 15, et dans ce cas, la puce est positionnée dans le plan de préhension, sensiblement parallèle au plan du support sur lequel la puce est destinée à être collée. La deuxième extrémité 18 du dispositif d'incurvation 16 se translate vers la puce jusqu'à entrer en contact et appliquer une force contrôlée afin de déformer la puce au point de contact entre la deuxième extrémité 18 et la puce. Soit la deuxième extrémité 18 du dispositif d'incurvation 16 se trouve au-delà du plan de contact 15, et dans ce cas, les extrémités 26, 27 des ventouses 22, 23 ne sont pas encore mises en contact avec la puce. En approche de l'outil de positionnement de la puce, il y a d'abord contact de l'extrémité 18 avec la puce, et pendant l'approche de l'outil de positionnement et jusqu'à préhension de la puce par les ventouses, le dispositif d'incurvation 16 se contracte du fait de la diminution de distance imposée entre la base 13 et la puce, et du fait que la puce est encore positionnée sur son support initial plan. Autrement dit, l'extrémité 18 du dispositif d'incurvation 16 se translate par rapport à la puce selon l'axe Z dans le sens opposé au sens de translation du premier cas de figure, le dispositif d'incurvation 16 se contracte. Une fois la puce maintenue par le dispositif de préhension 14 (par exemple les ventouses 22, 23), la puce peut être soulevée de son support initial plan. A ce stade, il y a un relâchement de contrainte au niveau du dispositif d'incurvation 16 qui retrouve sa forme initiale, il se détend, son extrémité 18 se translate vers la puce et la déforme en leur point de contact. Ce cas de figure se rencontre par exemple avec un dispositif fixe à décalage pré-réglé par rondelles d'épaisseur. La forme de la base 13, le nombre et la répartition des ventouses peuvent être adaptés selon la forme et la taille de la puce à manipuler.

Avantageusement, mais non nécessairement, le dispositif d'incurvation 16 est positionné entre les au moins deux ventouses. Cela permet une meilleure répartition des forces appliquées sur la puce, tant en termes de maintien en position dans un plan qu'en termes d'application de force pour courber la puce.

Dans un mode de réalisation particulièrement avantageux pour la préhension de la puce, les au moins deux ventouses 22, 23 sont reliées à un réseau de vide 31. L'étape de préhension de la puce sera décrite ci-dessous.

Le dispositif d'incurvation 16 peut être un doigt presseur, un ressort, une ventouse à soufflet, une vis de pression ou une rotule permettant de conformer le parallélisme de la puce dans le plan de préhension 15. Il peut aussi être un ensemble de rondelle permettant d'ajuster la hauteur du dispositif d'incurvation 16, c'est-à-dire permettant d'ajuster la distance entre ses deux extrémités et par là même de translater la deuxième extrémité 18 par rapport à la première extrémité 17 reliée à la base 13.

Les au moins deux ventouses 22, 23 reliées au réseau de vide 31 assurent la fonction de préhension de la puce. Le dispositif d'incurvation 16 n'est pas relié au réseau de vide. Son extrémité 18 est réglée pour être déplacée à travers le plan de préhension 15 et être positionnée par rapport à la base 13 à une distance supérieure que la distance entre le plan de préhension 15 et la base 13.

Avantageusement, les au moins deux ventouses 22, 23 comprennent du silicone. Les ventouses dissipatives en silicone limitent les risques d'indentation des couches et de dommages liés aux décharges électrostatiques.

L'utilisation de ventouses du commerce convient tout à fait à la mise en oeuvre de l'outil de positionnement 20 selon l'invention. L'utilisation de consommables (ventouses) standard facilite l'approvisionnement et permet de garantir des prix raisonnables de fournitures courantes. Cela permet aussi un choix des duretés et caractéristiques électriques des ventouses, notamment pour l'aspect dissipatif pour limiter les risques liés aux charges électrostatiques.

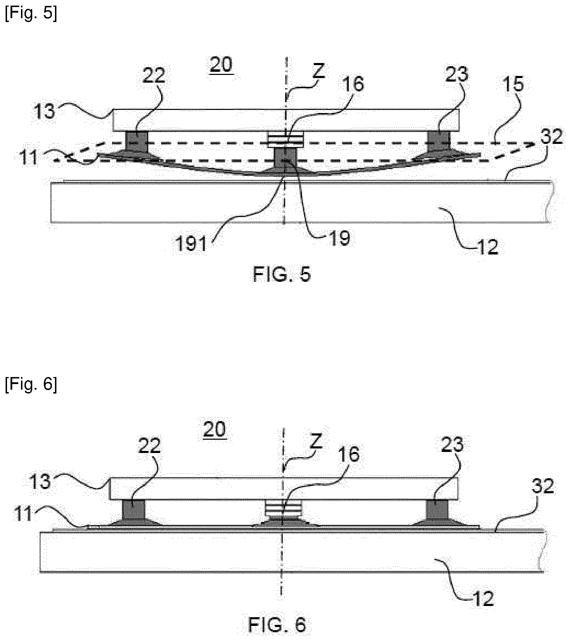

La figure 3 représente schématiquement les étapes du procédé de positionnement d'une plaque plane sur un support plan selon l'invention. Le procédé de positionnement d'une plaque plane 11 (puce de grandes dimensions) sur un support plan 12 (capteur) comprend les étapes suivantes. Tout d'abord, il y a une étape 100 de préhension de la plaque plane 11 par un dispositif de préhension 14. Lors de cette étape, la puce est saisie par l'outil de positionnement 20, plus précisément par le dispositif de préhension 14, et positionnée dans le plan de préhension. Ensuite, il y a une étape 101 de maintien de la plaque plane 11 dans le plan de préhension 15. Enfin, le procédé selon l'invention comprend une étape 102 d'incurvation de la plaque plane 11 par translation selon un premier axe Z sécant, préférentiellement sensiblement perpendiculaire, d'une deuxième extrémité 18 d'un dispositif d'incurvation 16 à travers le plan de préhension 15 en un point de contact 19 de sorte à former un point de courbure 191 de la plaque plane 11. La plaque plane 11 est alors courbée en un point de courbure 191, comme visible sur la figure 5. Avantageusement, l'étape 102 d'incurvation a lieu après l'étape 100 de préhension et l'étape 101 de maintien. Toutefois, il est aussi envisageable, notamment dans le cas où les ventouses sont reliées au réseau de vide, d'incurver (étape 102) la plaque plane en même temps que l'étape de préhension et l'étape de maintien.

Le procédé de positionnement peut comprendre après l'étape 102 d'incurvation de la plaque plane 11 une étape 103 de mise en contact du point de courbure 191 de la plaque plane 11 incurvée avec le support plan 12. Le procédé de positionnement peut enfin comprendre après l'étape 103 de mise en contact une étape 104 de libération de la plaque plane 11 sur le support plan 12. A ce stade, la puce 11 est collée sur le capteur 12 avec la précision voulue (de quelques micromètres), sans formation de bulles dans la colle. Vient ensuite une étape 104 de libération de la plaque plane 11 sur le support plan 12 lors de laquelle l'outil de positionnement se désolidarise de la plaque plane 11 alors collée sur son support.

La figure 4 représente schématiquement l'outil de positionnement 20 selon l'invention lors de l'étape 100 de préhension de la puce 11 par un dispositif de préhension 14. Sur cette figure, la puce 11 n'est pas représentée mais elle peut être assimilée au plan de préhension 15 dans lequel elle est positionnée après avoir été saisie par l'outil. Nous voyons deux ventouses, mais il pourrait tout à fait en avoir plus, par exemple quatre positionnées à proximité des quatre coins de la base 13, et le dispositif d'incurvation 16 est alors positionné au centre des quatre ventouses. Dans le cas où le dispositif de préhension 14 comprend des ventouses reliées au réseau de vide 31, les ventouses approchent la surface plane de la puce 11. Les ventouses 22, 23 sont soumises au vide qui aspire la puce repoussée par la pression atmosphérique. Les ventouses et la puce sont ainsi maintenues solidaires, et la puce est positionnée dans le plan de préhension 15 défini par les deuxièmes extrémités des ventouses. A ce stade du procédé, la puce 11 est maintenue dans le plan de préhension 15.

La figure 5 représente schématiquement l'outil de positionnement 20 selon l'invention lors de l'étape 102 d'incurvation de la puce 11. Le dispositif de préhension 14 assure le maintien de la puce qui est solidaire de l'outil de positionnement 20. Lors de l'étape 102 d'incurvation, la deuxième extrémité 18 du dispositif d'incurvation 16, par exemple un doigt presseur, se translate selon l'axe Z vers le plan de préhension 15 jusqu'à entrer en contact avec le plan de préhension 15 au point de contact 19 (premier cas de figure décrit précédemment) ou se translate selon l'axe Z vers la base 13 en se contractant (deuxième cas de figure décrit précédemment). Après la préhension de la puce et quand la puce est soulevée de son support plan initial, la deuxième extrémité 18 applique une force sur la puce 11 au point de contact 19. Au niveau du point de contact 19, la puce 11 se courbe. La puce 11 n'est plus totalement dans le plan de préhension 15 du fait de la courbure de la puce 11 qui présente alors un point de courbure 191.

Il faut noter que la déformation de la puce est représentée de manière exagérée pour permettre l'illustration du principe. Le montage des ventouses du dispositif de préhension 15 et du dispositif d'incurvation 16 est avantageusement réalisé de sorte à permettre une position plus basse de quelques centaines de microns pour le dispositif d'incurvation 16, par rapport au plan de préhension 15. La déformation d'une puce 11 ayant une épaisseur de l'ordre de 400 micromètres est de l'ordre de 100 micromètres. Cela permet d'éviter un accostage de la puce 11 sur le film adhésif 32 sur un bord ou un coin en garantissant un accostage en zone centrale. La force nécessaire n'excédant pas quelques centaines de grammes permet de préserver les couches en surface de la plaque plane (puce 11).

La figure 6 représente schématiquement l'outil de positionnement 20 selon l'invention après l'étape 103 de mise en contact de la puce 11 sur son support 12. L'outil de positionnement 20 s'approche du support 12 jusqu'à la mise en contact du point de courbure 191 de la puce sur le support. Grâce à la courbure de la puce 11, il est aisé de positionner ce point à l'endroit souhaité sur le support. Il n'y a pas de risque d'effet de bord qui ferait qu'un bord ou un coin toucherait le film adhésif 32 sur le support 12. Après l'étape 103 de mise en contact de la puce 11 sur le support 12, il y a une libération de la puce 11 sur le support plan 12. Cette étape peut aussi être dénommée étape de dépose. Le dispositif de préhension 14 libère la puce 11 alors en place sur son support, et l'outil de positionnement 20 est désolidarisé de la puce 11. Dans le cas où le dispositif de préhension 14 comprend des ventouses reliées au réseau de vide 31, l'étape 104 de libération de la puce correspond à la fin d'aspiration dans laquelle le vide est interrompu pour relâcher la puce 11. Comme on le voit sur la figure 6, la puce 11 est de nouveau plane. Le dispositif de préhension 14 ne retient plus la puce 11 et comme le dispositif d'incurvation 16 n'applique aucune force sur la puce 11, hormis la force selon l'axe Z pour la courber en vue de son positionnement sur le support plan 12, l'outil de positionnement peut être utilisé pour la préhension et le positionnement d'une autre puce 11.

La solution apportée repose donc sur la préhension et le maintien d'une puce dans un plan de préhension 15 et la courbure de cette puce pour permettre un accostage du point de courbure de la puce sur le capteur support plan. Cette solution permet de limiter les effets de mouvement de la puce lors de la phase de collage sur le capteur support plan.

Le collage de la puce se fait donc du centre de la puce vers ses bords. Il en résulte une limitation de la création de bulles à l'interface entre la puce et le support plan. L'avantage qui découle de l'absence de bulles, ou tout du moins de la limitation de la création de bulles, est l'obtention d'une structure hermétique et étanche.

Avantageusement, le dispositif de préhension comprend plusieurs ventouses coplanaires assurant la fonction de préhension de la puce, et le dispositif d'incurvation a une deuxième extrémité non coplanaire avec les ventouses du dispositif de préhension qui est configurée pour assurer la fonction de courbure contrôlée de la puce.

L'invention s'applique préférentiellement, mais de manière non limitative, au report de puces silicium de dimensions supérieures à 20 mm x 20 mm sur film adhésif. Par extension, l'invention s'applique à tout procédé de report de plaques planes pouvant être déformées, même faiblement, sous contraintes avec des contraintes fortes sur la tolérance de positionnement et l'absence de bulles dans la colle à l'interface entre la plaque plane et le support sur lequel la plaque plane est destinée à être reportée.

## Revendications

1. Outil de positionnement (10, 20) apte à courber ponctuellement une plaque plane pour positionner la plaque plane (11) sur un support plan (12), ledit outil de positionnement (10, 20) comprenant:
a. une base (13) ;
b. un dispositif de préhension (14) relié à la base (13), définissant un plan de préhension (15), le dispositif de préhension (14) étant apte à saisir une première surface de la plaque plane (11) et la maintenir dans le plan de préhension (15), le dispositif de préhension (14) comprenant au moins deux ventouses (22, 23), chacune ayant une première extrémité (24, 25) reliée à la base (13) et une deuxième extrémité (26, 27) située dans le plan de préhension (15), les au moins deux ventouses (22, 23) étant reliées à un réseau de vide (31);
c. un dispositif d'incurvation (16), ayant une première extrémité (17) reliée à la base (13) et une deuxième extrémité (18) mobile en translation selon un premier axe Z sécant, préférentiellement sensiblement perpendiculaire, à travers le plan de préhension (15) en un point de contact (19), le dispositif d'incurvation (16) étant configuré pour appliquer une force de poussée sur la première surface de la plaque plane (11) en un point de courbure, de sorte à courber la plaque plane (11) en ce point de courbure (191).

2. Outil de positionnement (10, 20) selon la revendication 1, **caractérisé en ce que** le dispositif d'incurvation (16) est un contact ponctuel (21).

3. Outil de positionnement (20) selon la revendication 1 ou 2, **caractérisé en ce que** le dispositif d'incurvation (16) est positionné entre les au moins deux ventouses (22, 23).

4. Outil de positionnement (20) selon l'une quelconque des revendications 1 à 3, **caractérisé en ce que** les au moins deux ventouses (22, 23) comprennent du silicone.

5. Outil de positionnement (10, 20) selon l'une quelconque des revendications 1 à 4, **caractérisé en ce que** le dispositif d'incurvation (16) est un doigt presseur, un ressort, une ventouse à soufflet, une vis de pression ou une rotule.

6. Procédé de courbure ponctuelle d'une plaque plane pour positionner la plaque plane (11) sur un support plan (12), ledit procédé comprenant les étapes suivantes:
a. Préhension (100) d'une première surface de la plaque plane (11) par un dispositif de préhension (14);
b. Maintien (101) de la plaque plane (11) dans un plan de préhension (15) ;
c. Incurvation (102) de la plaque plane (11) par translation selon un premier axe Z sécant, préférentiellement sensiblement perpendiculaire, d'une deuxième extrémité (18) d'un dispositif d'incurvation (16) à travers le plan de préhension (15) en un point de contact (19) et application d'une force de poussée sur la première surface de la plaque plane (11) en un point de courbure, de sorte à courber la plaque plane (11) en ce point de courbure (191) de la plaque plane (11).

7. Procédé de positionnement selon la revendication 6, **caractérisé en ce qu'**il comprend après l'étape (102) d'incurvation de la plaque plane (11) une étape (103) de mise en contact du point de courbure (191) de la plaque plane (11) incurvée avec le support plan (12).

8. Procédé de positionnement selon la revendication 7, **caractérisé en ce qu'**il comprend après l'étape (103) de mise en contact une étape (104) de libération de la plaque plane (11) sur le support plan (12).

## Patentansprüche

1. Positionierungswerkzeug (10, 20), das zum punktuellen Biegen einer ebenen Scheibe zum Positionieren der ebenen Scheibe (11) auf einem ebenen Träger (12) in der Lage ist, wobei das Positionierungswerkzeug (10, 20) Folgendes umfasst:
a. eine Basis (13);
b. eine mit der Basis (13) verbundene Greifvorrichtung (14), die eine Greifebene (15) definiert, wobei die Greifvorrichtung (14) zum Ergreifen einer ersten Oberfläche der ebenen Scheibe (11) und zum Halten derselben in der Greifebene (15) in der Lage ist, wobei die Greifvorrichtung (14) mindestens zwei Saugnäpfe (22, 23) umfasst, von denen jeder ein mit der Basis (13) verbundenes erstes Ende (24, 25) und ein in der Greifebene (15) befindliches zweites Ende (26, 27) aufweist, wobei die mindestens zwei Saugnäpfe (22, 23) mit einem Vakuumnetz (31) verbunden sind;
c. eine Biegevorrichtung (16) mit einem mit der Basis (13) verbundenen ersten Ende (17) und einem zweiten Ende (18), das entlang einer ersten, vorzugsweise im Wesentlichen lotrechten Schnittachse Z durch die Greifebene (15) an einem Kontaktpunkt (19) translatorisch beweglich ist, wobei die Biegevorrichtung (16) so konfiguriert ist, dass sie an einem Biegepunkt eine Schubkraft auf die erste Oberfläche der ebenen Scheibe (11) ausübt, sodass die ebene Scheibe (11) an diesem Biegepunkt (191) gebogen wird.

2. Positionierungswerkzeug (10, 20) nach Anspruch 1, **dadurch gekennzeichnet, dass** die Biegevorrichtung (16) ein Punktkontakt (21) ist.

3. Positionierungswerkzeug (20) nach Anspruch 1 oder 2, **dadurch gekennzeichnet, dass** die Biegevorrichtung (16) zwischen den mindestens zwei Saugnäpfen (22, 23) positioniert ist.

4. Positionierungswerkzeug (20) nach einem der Ansprüche 1 bis 3, **dadurch gekennzeichnet, dass** die mindestens zwei Saugnäpfe (22, 23) Silikon umfassen.

5. Positionierungswerkzeug (10, 20) nach einem der Ansprüche 1 bis 4, **dadurch gekennzeichnet, dass** die Biegevorrichtung (16) ein Druckfinger, eine Feder, ein Balgsaugnapf, eine Druckschraube oder ein Kugelgelenk ist.

6. Verfahren zum punktuellen Biegen einer ebenen Scheibe zum Positionieren der ebenen Scheibe (11) auf einem ebenen Träger (12), wobei das Verfahren die folgenden Schritte umfasst:
a. Greifen (100) einer ersten Oberfläche der ebenen Scheibe (11) durch eine Greifvorrichtung (14);
b. Halten (101) der ebenen Scheibe (11) in einer Greifebene (15);
c. Biegen (102) der ebenen Scheibe (11) durch eine translatorische Bewegung eines zweiten Endes (18) einer Biegevorrichtung (16) durch die Greifebene (15) an einem Kontaktpunkt (19) entlang einer ersten, vorzugsweise im Wesentlichen lotrechten Schnittachse Z und Aufbringen einer Schubkraft auf die erste Oberfläche der ebenen Scheibe (11) an einem Biegepunkt, um die ebene Scheibe (11) an diesem Biegepunkt (191) der ebenen Scheibe (11) zu biegen.

7. Positionierungsverfahren nach Anspruch 6, **dadurch gekennzeichnet, dass** es nach dem Schritt (102) des Biegens der ebenen Scheibe (11) einen Schritt (103) des Kontaktierens des Biegepunkts (191) der gebogenen ebenen Scheibe (11) mit dem ebenen Träger (12) umfasst.

8. Positionierungsverfahren nach Anspruch 7, **dadurch gekennzeichnet, dass** es nach dem Schritt (103) des Kontaktierens einen Schritt (104) des Freigebens der ebenen Scheibe (11) auf den ebenen Träger (12) umfasst.

## Claims

1. A positioning tool (10, 20) able to bend a flat wafer at specific points to position the flat wafer (11) on a flat support (12), said positioning tool (10, 20) comprising:
a. a base (13);
b. a gripping device (14) connected to the base (13), defining a gripping plane (15), the gripping device (14) being able to grasp a first surface of the flat wafer (11) and hold it in the gripping plane (15), the gripping device (14) comprising at least two suction cups (22, 23), each having a first end (24, 25) connected to the base (13) and a second end (26, 27) located in the gripping plane (15), the at least two suction cups (22, 23) being connected to a vacuum network (31);
c. a bending device (16), having a first end (17) connected to the base (13) and a second end (18) translationally movable along a first intersecting axis Z, which is preferably substantially perpendicular, through the gripping plane (15) at a contact point (19), the bending device (16) being configured to apply a pushing force onto the first surface of the flat wafer (11) at a bending point, so as to bend the flat wafer (11) at this bending point (191).

2. The positioning tool (10, 20) according to claim 1, **characterised in that** the bending device (16) is a point contact (21).

3. The positioning tool (20) according to claim 1 or 2, **characterised in that** the bending device (16) is positioned between the at least two suction cups (22, 23).

4. The positioning tool (20) according to any one of claims 1 to 3, **characterised in that** the at least two suction cups (22, 23) comprise silicon.

5. The positioning tool (10, 20) according to any one of claims 1 to 4, **characterised in that** the bending device (16) is a presser finger, a spring, a bellows suction cup, a pressure screw, or a ball joint.

6. A method for bending a flat wafer at specific points to position the flat wafer (11) on a flat support (12), said method comprising the following steps:
a. gripping (100) a first surface of the flat wafer (11) by means of a gripping device (14);
b. holding (101) the flat wafer (11) in a gripping plane (15);
c. bending (102) the flat wafer (11) through translational movement along a first intersecting axis Z, which is preferably substantially perpendicular, of a second end (18) of a bending device (16) through the gripping plane (15) at a contact point (19) and applying a pushing force onto the first surface of the flat wafer (11) at a bending point, so as to bend the flat wafer (11) at this bending point (191) of the flat wafer (11).

7. The positioning method according to claim 6, **characterised in that** it comprises, after the step (102) of bending the flat wafer (11), a step (103) of bringing the bending point (191) of the curved flat wafer (11) into contact with the flat support (12).

8. The positioning method according to claim 7, **characterised in that** it comprises, after the contact step (103), a step (104) of releasing the flat wafer (11) onto the flat support (12).
